Europäisches Patentamt

European Patent Office

Office européen des brevets

(11) Publication number: **0 296 707**
**A1**

(12) # EUROPEAN PATENT APPLICATION

(21) Application number: 88304254.1

(22) Date of filing: 11.05.88

(51) Int. Cl.⁴: **H01L 21/31** , **H01L 21/90**

(30) Priority: 12.06.87 US 61850

(43) Date of publication of application:
28.12.88 Bulletin 88/52

(84) Designated Contracting States:
**DE FR GB**

(71) Applicant: **HEWLETT PACKARD COMPANY**
**Legal Department 3000 Hanover Street**
**Palo Alto, CA 94304(US)**

(72) Inventor: **Kessler, Daniel Dean**
**1536 Preston Trail**
**Fort Collins Colorado 80525(US)**
Inventor: **Beatty, Christopher C.**
**2731 Granada Hills Drive**
**Fort Collins Colorado 80525(US)**
Inventor: **Wu, Robert W.**
**1613 Shenandoa Circle**
**Fort Collins Colorado 80525(US)**
Inventor: **Crook, Mark D.**
**2918 Adobe Drive**
**Fort Collins Colorado 80525(US)**

(74) Representative: **Colgan, Stephen James et al**
**CARPMAELS & RANSFORD 43 Bloomsbury**
**Square**
**London WC1A 2RA.(GB)**

(54) Incorporation of dielectric layers in a semiconductor.

(57) A system for integrating a composite dielectric
layer in an integrated circuit to facilitate fabrication of
a high density multi-level interconnect with external
contacts. The composite dielectric layer comprises
of a polymer layer (20) which normally comprises a
polyimide that is deposited using conventional spin-
deposit techniques to form a planarized surface (22)
for deposition of an inorganic layer (24), typically
comprising silicon dioxide, or silicon nitride. The
inorganic layer (24) is etched using standard
photoresist techniques to form an inorganic mask
(30) for etching the polymer layer (20). A previously
deposited inorganic layer functions as an etch stop
to allow long over etches to achieve full external
contacts which, in turn, allows high density intercon-
nect systems on multiple levels.

Fig.5

## INCORPORATION OF DIELECTRIC LAYERS IN A SEMICONDUCTOR

### Background of the Invention

#### A. Field of Invention

The present invention pertains generally to fabrication of semiconductors and more particularly fabrication of integrated circuit devices using a composite dielectric layer.

#### B. Description of the Background

Spin-on polymers such as polyimides are widely recognized as excellent dielectric materials for use in fabricating multi-level interconnects. Although these polymers perform an excellent job of planarizing underlying topography, the polymer layers are generally found to have low-yield strength relative to inorganic dielectrics and poor dry etch selectivity to commonly used photolithographic masking materials. As a result, highly stressed conductor materials, which have a number of advantageous features, cannot be used in combination with spin-on polymers.

Additionally, when spin-on polymers are placed over a varying topography, feature dependent thickness variations result. In other words, although the upper surface of the polymer layer is planarized, the depth of the polymer layer varies in accordance with the height of the underlying structures. These variations greatly complicate the etching of vias, i.e., vertical openings that allow the connection of conductors between multiple layers. Vias over thin polymer regions must be capable of sustaining long etches without creating unwanted connections to underlying areas while the vias in the thicker polymer regions are being etched. Generally, this problem is avoided by requiring the via features to be internal to the underlying metal features to which the contact is being made. In other words, the vias, or openings, must be fully enclosed by underlying metal features so that during the process of etching the polymer layer, over-etching can be achieved without damaging the underlying structure since the polymer etcher will not etch the metal feature. This requires that dogbones, i.e., enlarged metal features, be employed to ensure full vertical registration of the vias with the metal features. However, dogbones severally limit the density of circuitry that can be achieved in the integrated circuit device.

Fabrication of highly dense, multi-level interconnections necessitates the ability to planarize underlying topography so that submicron etching can be achieved with high fidelity. In other words, the flat surface of the semiconductor layer facilitates detailed masking at a submicron level. Additionally, the fabrication of highly dense, multi-level interconnection underlying metal features to which contact is to be made. In other words, the vias, or openings, can extend over the edges underlying feature. these characteristics have not been achieved by prior art devices.

### Summary of the Invention

The present invention overcomes the disadvantages of the prior art by providing a multi-level dielectric layer comprising a polymer and an inorganic material. The polymer material provides a substantially planar surface on which an inorganic layer is deposited. The inorganic layer acts as a non-erodible etch mask during polymer patterning and eliminates etch selectivity concerns between the polymer and the photolithographic mask, allowing small features to be easily transferred into the polymer using standard dry etch techniques. Additionally, when the composite comprising the polymer and inorganic layer is employed in a multi-level interconnect process, the inorganic layer from the previous level provides an etch stop for the polymer via etch. This allows vias to be external to the underlying metal features without concerns of accidentally creating unwanted interconnections to conductors below these features. Moreover, through proper selection of the inorganic material, the composite strength of the polymer/inorganic composite layer is greatly increased. This allows the use of spin-on polymers in combination with highly stressed conductor materials such as tungsten.

### Brief Description of the Drawings

Figure 1 is a schematic illustration of an initial stage of fabrication of the device of the present invention illustrating the deposition of a polymer layer on an existing integrated circuit.

Figure 2 illustrates a subsequent stage illustrating the inorganic layer prior to etching.

Figure 3 illustrates the device of Figure 2 after etching of the inorganic and polymer layers.

Figure 4 illustrates the device of Figure 3 after deposition of metal features.

Figure 5 is a schematic flow diagram of the process of the present invention.

Detailed Description of the Invention

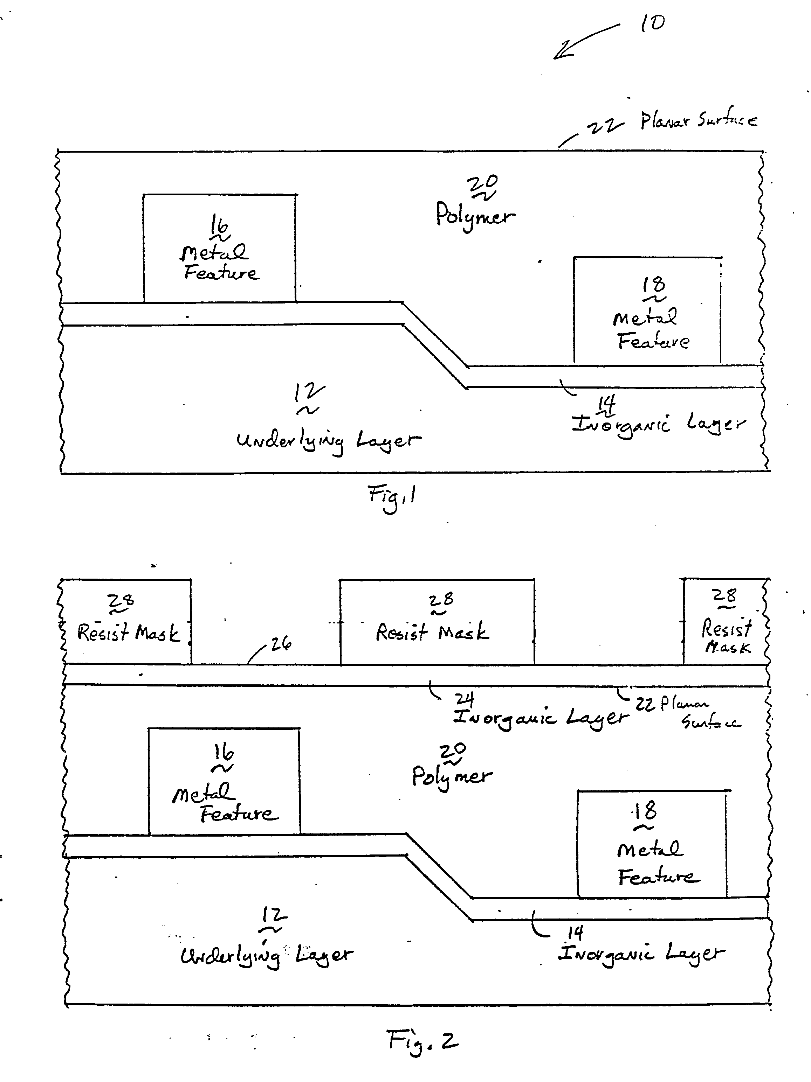

Figure 1 schematically illustrates a semiconductor device 10 having an underlying layer 12 that has a predetermined topology, as schematically illustrated by the sloped structure. Inorganic layer 14 can comprise an inorganic material deposited in an initial state of the process of the present invention, or can comprise a second inorganic masking layer of a lower structure in a multi-level process that was previously deposited in accordance with the present invention. Metal features 16 and 18 are deposited and etched on inorganic layer 14, and a polymer layer 20, is deposited on the structure to provide a substantially planar surface 22. The polymer 20, which can comprise any one of a number of standard polyimides, is suspended in a solvent and deposited on the surface of the semiconductor. A typical example of integrated circuit grade polyimide brands include Dupont DP2545, DP2555 and DP2566 available from Dupont Corporation, Hitachi PIQ-13, PIX-1400, PIX-L100, PIX-L110, PIX-L120 available from Hitachi Corporation. Chemical names for these polyimides comprise the following:

p-PDA/S-BPDA, DATP/PMDA, PMDA/ODA, DDE/BTDA

PMDA and BTDA are more fully disclosed in "Thermal Expansion Behavior of Various Aeromatic Polyimides", Polymer Journal, Vol. 17, No. 8, pp. 981-983, 1985.

The semiconductor is then spun to uniformly distribute the polymer material across the surface of the semi-conductor device 10 in a uniform manner to produce planar surface 22. The solvent is then removed using standard thermal curing techniques. For example, the wafer can be placed on a hot plate in clean room airflow at 85°C for 60 seconds and then placed in an oven at a 100°C in nitrogen flowing at 6 liters per minute for 30 minutes. The wafer is then baked at 200°C in nitrogen flowing at 6 liters per minute for 30 minutes and then at 450°C in nitrogen flowing at 12 liters per minutes for 30 minutes. After the polymer deposition process is completed, the substrate is then baked at low temperature to drive out any moisture absorbed by the polymer. For example, the wafer can be placed in a 200C nitrogen flowing oven for 30 minutes. A typical thickness of the polymer achieved by the above process is 4000 angstroms. The surface of the polymer is then roughen to improve the adhesion of subsequently deposited layers. This is accomplished by exposing the substrate to a plasma environment.

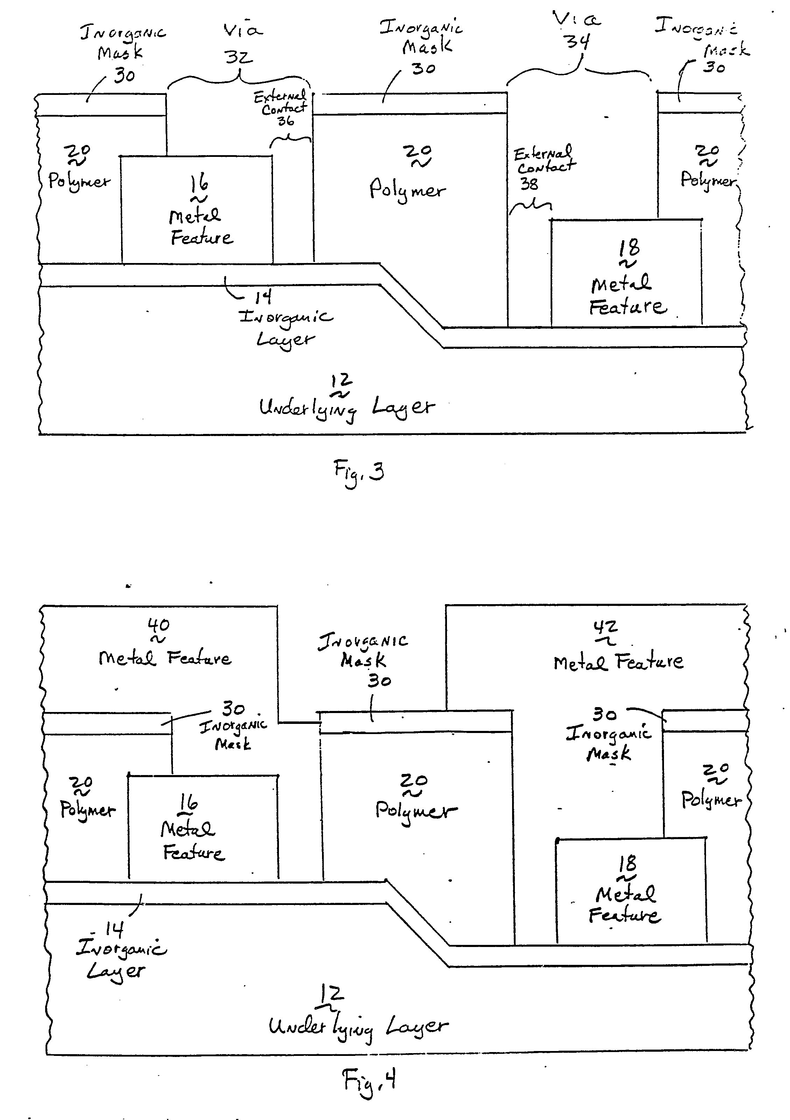

The second inorganic layer 24 is then deposited on planar surface 22 of polymer 20, as illustrated in Figure 2. Figure 2 illustrates the structure of Figure 1, including metal features 16 and 18, first inorganic layer 14 and underlying layer 12. The manner of deposition, thickness and composition of inorganic layer 22 are chosen to be compatible with the underlying polymer layer 20 to provide the required strength for the composite dielectric sandwich including inorganic layer 24 and polymer 20 when used with a particular metal feature to be deposited on the upper surface of 26 of inorganic 24. Typical examples of materials which can be used as inorganic layer 24 include doped and undoped silicon dioxide and silicon nitride. Common methods of applying silicon dioxide layers include plasma enhanced vapor deposition and atmospheric pressure deposition techniques. Silicon nitride layers can be applied using plasma enhanced chemical deposition vapor techniques. For example, the following conditions can be utilized:

Pressure = 1.4 torr
Power = 120 watts
Temperature = 400°C
$NH_3:SiH_4$ ratio = 8
Total flow = 2361 SCCM

Atmospheric Pressure Chemical Vapor Deposition (APCVD) oxide conditions comprise the following:

Pressure = 1 atmosphere
$O_2$:Hydride Ratio = 27:1
$O_2$ = 4.48 SCCM
$H_2$ = 6.56 SCCM
$SiH_4$ = 0.045 SCCM
$PH_3$ = 0.067 SCCM
Temperature = 415°C

Patterning of vias in the dielectric composite is accomplished using standard photolithographic techniques and common resist masking materials. As illustrated in Figure 2, resist mask 28 is formed using these standard methods. Inorganic layer 24 is resistant to the etching material for the resist mask 28.

Figure 3 illustrates the manner in which the inorganic layer 24 and polymer layer 20 are etched in accordance with the present invention. The etching process is carried out with a reactive ion etcher to minimize lateral linewidth loss. The anisotropic nature of the reactive ion etcher additionally minimizes undercutting of the polymer layer 20. The etching process is performed in two phases. In the first phase, the inorganic layer 24 (Figure 2) is etched using the resist mask 28 (Figure 2) as a pattern mask. A typical example of an etch gas used to etch the inorganic layer 24 (Figure 2)

comprises CF$_4$. The etching process is stopped after the polymer is exposed in the openings between the resist mask 28. As shown in Figure 3, an inorganic mask 30 is then formed which can be used to etch the polymer layer 20, comprising the second phase of the etching process. Gases to be used on the reactive ion etcher during the second phase of the etching process are chosen to maximize feature linewidth control since selectivity to the organic mask 30 is not a concern. Typical etching gasses employed include O$_2$ in combination with noble gasses such as argon. Oxygen:Argon mixtures can range from 0 to 50% argon to produce etch rates of polyimide of 200 to 400 angstroms per minute.

The process of etching the polymer layer 20 results in the formation of vias, such as vias 32 and 34 illustrated in Figure 3. Since there is not full vertical registration between the inorganic mask 30 and underlying metal features 16 and 18, external contacts result such as external contacts 36 and 38, respectively. Long overetches are possible even with the existence of external contacts 36 and 38 since the polymer layer 20 is always placed over inorganic layer 14 which can be initially deposited in the process of the present invention, or can comprise an inorganic mask layer, such as inorganic mask layer 30 of a lower dielectric layer of multi-level structure previously deposited in accordance with the present invention. Design criteria never allow a metal feature, such as metal feature 16 or 18, to be placed over lower vias, so that the inorganic mask is always below external contacts 36 and 38 to prevent etching into the underlying layer 12. This differs from the prior art in that the layer below the metal features 16 and 18 typically comprise another polymer layer 20 which would be etched during long over-etches of polymer layer 20. Hence, inorganic layer 14 functions as an etch stop for the polymer etch process so as to prevent unwanted interconnections to underlying conductors.

Following the via etches, any remaining photoresist is removed from the device using common resist strip solutions which are compatible with the polymers such as J100 and J100NP available from Industri-Chem located in Richardson, Texas. The device is then baked at a low temperature to drive out any moisture absorbed by the polymer in the via holes in accordance with the process described above.

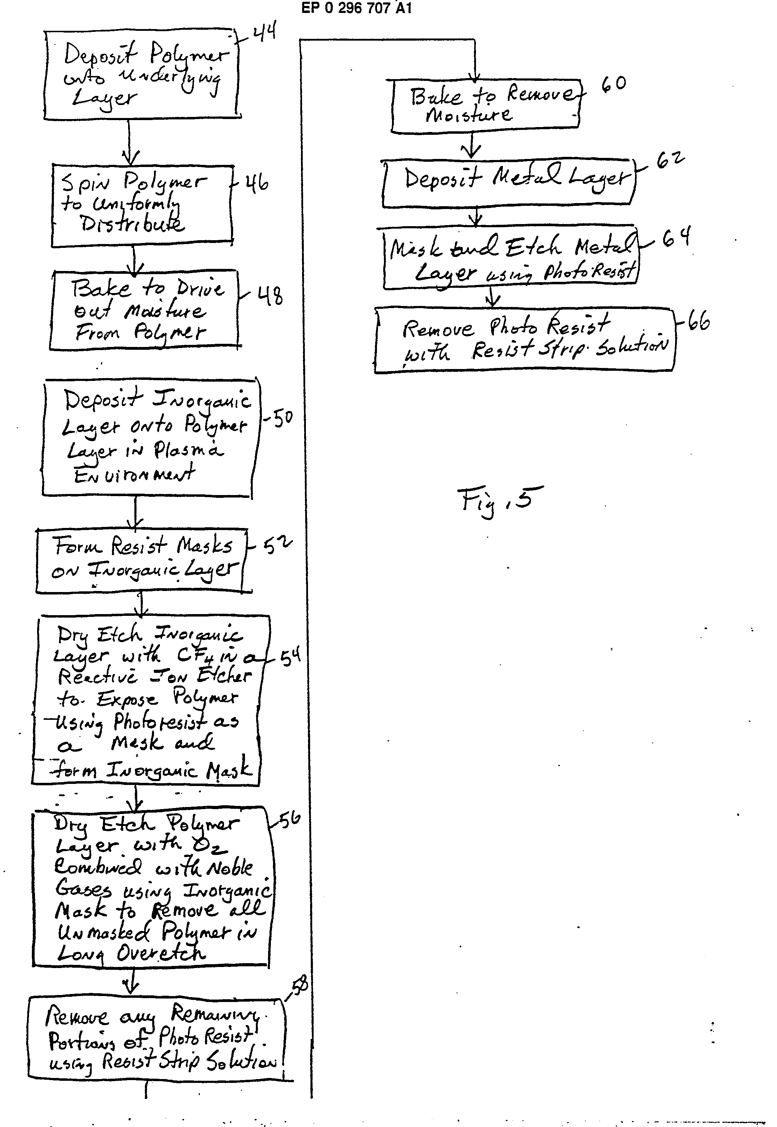

Figure 4 illustrates the manner in which metal features 40 and 42 are deposited in the device to provide full external contact with metal features 16 and 18, respectively. Metal features 40 and 42 can be deposited using standard sputtering or chemical vapor deposition techniques. If step coverage in the vias is a concern, techniques which fill the vias with metal can be employed, including bias sputtering, CVD metal deposition and the formation of metal plugs using various tungsten metal processing techniques. When plug techniques are employed, subsequent blanket metal deposition is usually necessary such as low-pressure chemical vapor deposition of tungsten and aluminum. The resulting film is used for patterning the conductor lines. After metal deposition, the metal is patterned using standard photolithographic techniques and a suitable mask. An etch compatible with a conductor metal and mask is then used to pattern the conductor features. This process is followed by a resist strip process to remove any remaining masking material. This process can be repeated to provide multiple vertically disposed layers and so as to produce the desired number of interconnect levels.

Figure 5 is a schematic flow diagram of the process of the present invention. As disclosed in Figure 5 at step 44, the polymer is deposited onto the underlying layer and spun to uniformly distribute the polymer across the surface of the wafer, as disclosed as step 46. The wafer is then baked to drive out moisture from the polymer as disclosed as step 48. The second inorganic layer 24 (Figure 2) is then deposited onto the polymer layer 20 (Figure 2) in a plasma environment to roughen the surface of the polymer layer, as disclosed as step 50. Resist masks 28 are then formed on the upper surface 26 (Figure 2) of inorganic layer 24 (Figure 2), as disclosed in step 52. Inorganic layer 24 (Figure 2) is then dry etched with a CF$_4$ plasma and a reactive ion etcher to expose polymer layer 20 (Figure 2) using the photoresist 28 as a mask to form an inorganic mask 30 (Figure 3), as disclosed as step 56. As disclosed as step 58, the remaining portions of the photoresist are removed using a resist stripping solution. The remaining structure is then baked to remove the moisture as disclosed at step 60. A metal layer is then deposited and etched using a photoresist, as disclosed as steps 62 and 64. The photresist is then removed with a resist strip solution as disclosed at step 66.

The present invention therefore provides a unique method of utilizing an inorganic layer over a spin-on polymer to act as a non-erodible mass during etching of the polymer. The application of this inorganic layer to also provide an etch stop during the polymer etch in vias in a multiple layer structure allows for long overetches to be achieved so that dense interconnect systems can be fabricated employing external contacts. Since the inorganic layer is not susceptible to the polymer etching, high process margin is available for the via etch step.

Additionally, the use of an inorganic layer to improve the strength of the polymer dielectric comprises a unique aspect of the present invention.

Through proper selection of the inorganic layer, the capability to utilize higher stress conductor materials such as tungsten is achieved. The use of tungsten is desirable because tungsten is not susceptible to electrical migration problems. Low pressure chemical vapor deposition techniques of depositing tungsten allow full vertical inner-connections for external contacts since this process of depositing the tungsten provides uniform coverage in the vias and external contacts. Spin-on polymers are simple and inexpensive to implement providing an excellent low-cost means of creating the desired planar surfaces required at each inter-connect level. The addition of an inorganic layer on the surface of the polymer layer provides a path for integrating these materials to create very high density interconnect systems.

The foregoing description of the invention has been presented for purposes of illustration and description. it is not intended to be exhaustive or to limit the invention to precise form disclosed, and other modifications and variations may be possible in light of the above teachings. The embodiment was chosen and described in order to best explain the principles of the invention and its practical application to thereby enable others skilled in the art to best utilize the invention in various embodiments and various modifications as are suited to the particular use contemplated. It is intended that the appended claims be construed to include other alternative embodiments of the invention except insofar as limited by the prior art.

**Claims**

1. A process for forming composite dielectric layers in an integrated circuit to facilitate high density multi-level interconnects with external contacts through the use high strength dielectric layers to support high stress metal layers characterized by the steps of:

forming a polymer layer (20) on a first inorganic layer of said semiconductor that is substantially uniformly distributed to provide a substantially planarized surface (22);

depositing a second inorganic layer (24) in said integrated circuit over said polymer layer (20);

forming a mask (28) on said inorganic layer (24):

etching said second inorganic layer (24) using said mask (28) as a masking pattern to form an inorganic mask (30) and provide a protective layer for etching of any subsequently deposited polymer layers;

etching said polymer layer (20) using said inorganic mask (30) as a masking pattern to essentially remove all polymer (20) unmasked by said inorganic mask (30) between said inorganic mask (30) and said first inorganic layer (14) such that said first inorganic layer (14) functions as a protective layer whenever said etching of said polymer layer continues after all of said unmasked polymer has been removed to fully expose external contact surfaces (36,38) of conductors to be connected to subsequently deposited metal layers (40,42).

2. A process according to claim 1 wherein said step of depositing said first inorganic layer (14), comprises depositing and etching a second inorganic layer of composite dielectric layers previously formed on said integrated circuit.

3. A process according to claim 1 or 2 wherein said step of forming said polymer layer (20) comprises the steps of:

depositing a polymer (20) suspended in a solvent on said inorganic layer (14);

uniformly distributing said polymer (20) suspended in said solvent by spinning said integrated circuit;

thermally curing said polymer (20) to remove said solvent.

4. A process according to any of claims 1 to 3 wherein said step of depositing said second inorganic layer (24) comprises applying silicon dioxide using plasma enhanced chemical vapor deposition.

5. A process according to any of claims 1 to 3 wherein said step of depositing said second inorganic layer (24) comprises applying silicon dioxide using atmospheric pressure deposition.

6. A process according to any of claims 1 to 3 wherein said step of depositing said second inorganic layer (24) comprises applying silicon nitride using plasma enhanced chemical vapor deposition.

7. A process according to any of claims 1 to 6 wherein said step of forming a mask (28) on said second inorganic layer (24) comprises:

depositing a photoresist layer on said second inorganic layer that is highly planarized so that small features can be transferred to said polymer layer;

exposing said photoresist layer using photolithographic techniques with a predetermined masking pattern;

etching said photoresist layer to produce a photoresist mask (28) essentially corresponding to said predetermined masking pattern.

8. A process according to any of claims 1 to 7 wherein said step of etching said second inorganic layer (24) comprises dry etching said second inorganic layer with carbon tetrafloride in a reactive ion etcher.

9. A process according to any of claims 1 to 8 wherein said step of etching said polymer layer (20) comprises dry etching said polymer layer (20) with oxygen and noble gas ions in a reactive ion etcher.

10. A composite dielectric layer in a semiconductor characterized by:

polymer layer means (20) deposited over a preselected surface of said semiconductor for forming a substantially planarized surface (22) suitable for submicron etching of features to be formed in said composite dielectric layer;

inorganic layer means (24) deposited over said polymer layer means for forming a mask (30) during the etching of said polymer layer (20) and for providing a protective layer during etching of subsequently deposited polymer layers and provide a composite structure that is sufficiently strong to support high stress metal layers.

11. A multi-level dielectric layer according to claim 10 wherein said polymer layer means (20) is a polyimide.

12. A multi-level dielectric layer according to claim 10 or 11 wherein said inorganic layer means (24) is silicon dioxide.

13. A multi-level dielectric layer according to claim 10 or 11 wherein said inorganic layer means (24) is silicon nitride.

10

22 Planar Surface

20
Polymer

16
Metal
Feature

18
Metal
Feature

12
Underlying Layer

14
Inorganic Layer

Fig. 1

28
Resist Mask

28
Resist Mask

28
Resist
Mask

26

24
Inorganic Layer

22 Planar
Surface

16
Metal
Feature

20
Polymer

18
Metal
Feature

12
Underlying Layer

14
Inorganic Layer

Fig. 2

Inorganic Mask 30

Via 32

Inorganic Mask 30

Via 34

Inorganic Mask 30

External Contact 36

20 Polymer

16 Metal Feature

20 Polymer

External Contact 38

18 Metal Feature

20 Polymer

14 Inorganic Layer

12 Underlying Layer

Fig. 3

40 Metal Feature

Inorganic Mask 30

42 Metal Feature

30 Inorganic Mask

20 Polymer

16 Metal Feature

20 Polymer

30 Inorganic Mask

20 Polymer

18 Metal Feature

14 Inorganic Layer

12 Underlying Layer

Fig. 4

Deposit Polymer onto Underlying Layer — 44

Spin Polymer to Uniformly Distribute — 46

Bake to Drive Out Moisture From Polymer — 48

Deposit Inorganic Layer onto Polymer Layer in Plasma Environment — 50

Form Resist Masks on Inorganic Layer — 52

Dry Etch Inorganic Layer with $CF_4$ in a Reactive Ion Etcher to Expose Polymer Using Photoresist as a Mask and Form Inorganic Mask — 54

Dry Etch Polymer Layer with $O_2$ Combined with Noble Gases using Inorganic Mask to Remove all Unmasked Polymer in Long Overetch — 56

Remove any Remaining Portions of Photo Resist using Resist Strip Solution — 58

Bake to Remove Moisture — 60

Deposit Metal Layer — 62

Mask and Etch Metal Layer using Photo Resist — 64

Remove Photo Resist with Resist Strip Solution — 66

Fig. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | EP-A-0 046 525 (IBM)<br>* Figures 11,12; page 12, line 25 - page 13, line 28; abstract; page 8, lines 26-31; page 10, line 27 - page 11, line 29 * | 1,2,4-6,8,10-13 | H 01 L 21/31<br>H 01 L 21/90 |
| Y | EP-A-0 103 879 (SIEMENS)<br>* Figures 1,2; page 3, lines 15-36; page 5, lines 10-19; page 6, lines 7-18; page 7, lines 7-15 * | 1-3,6,7,10-13 | |
| Y | US-A-4 495 220 (S. WOLF et al.)<br>* Figure 1; column 2, lines 23-57 * | 1-3,6,7,10-13 | |
| A | IEEE TRANSACTIONS ON ELECTRON DEVICES, vol. ED-34, no. 3, March 1987, pages 621-627, IEEE, New York, US; Y. MISAWA et al.: "A new multilevel interconnection system for submicrometer VLSI's using multilayered dielectrics of plasma silicon oxide and low-thermal-expansion polyimide"<br>* Figure 1; page 622, left-hand column, chapter III.B: "Fabrication process" * | 1,9,10 | |
| A | IBM TECHNICAL DISCLOSURE BULLETIN, vol. 27, no. 11, April 1985, pages 6783-6784, New York, US; "Via hole etch process through a polyimide/nitride composite layer"<br>* Whole article * | 8 | |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 04-10-1988 | MACHEK,J. |

EPO FORM 1503 03.82 (P0401)